# EUROPÄISCHE PATENTANMELDUNG

(11) **EP 3 570 439 A1**
(43) Veröffentlichungstag der Anmeldung: **20.11.2019**
(21) Anmeldenummer: 18172650.6
(22) Anmeldetag: 16.05.2018
(51) Int. Cl.: H03K 17/082, H03K 17/687

(54) **BEGRENZEN EINES ELEKTRISCHEN STROMS IN EINEM LEISTUNGSHALBLEITERSCHALTER**

(71) Anmelder: Siemens Aktiengesellschaft, 80333 München (DE)
(72) Erfinder: Göpfrich, Kurt, 96050 Bamberg (DE)

(57) **Zusammenfassung**

Die Erfindung betrifft eine Schaltungsanordnung (3) zum Begrenzen eines elektrischen Stroms in einem Leistungshalbleiterschalter (T1), der einen ersten Lastanschluss (D), einen zweiten Lastanschluss (S) und einen Steueranschluss (G) zum Steuern des Stroms zwischen den Lastanschlüssen (D, S) aufweist. Die Schaltungsanordnung (3) umfasst einen Shuntwiderstand (Rsh) mit einem ersten Shuntpol (P1), der mit dem zweiten Lastanschluss (S) des Leistungshalbleiterschalters (T1) elektrisch verbunden ist, und einen Bipolartransistor (T11), dessen Kollektor (C) mit dem Steueranschluss (G) des Leistungshalbleiterschalters (T1) elektrisch verbunden ist und dessen Basis-Emitter-Strecke elektrisch parallel zu dem Shuntwiderstand (Rsh) geschaltet ist.

## Beschreibung

Die Erfindung betrifft eine Schaltungsanordnung zum Begrenzen eines elektrischen Stroms in einem Leistungshalbleiterschalter, der entweder ein Feldeffekttransistor (FET = Field-Effective Transistor) oder ein Bipolartransistor mit isoliertem Gate (IGBT = Insulated-Gate Bipolar Transistor) ist. Ferner betrifft die Erfindung einen Wechselrichter mit derartigen Leistungshalbleiterschaltern.

Ein als ein FET und ein IGBT ausgebildeter Leistungshalbleiterschalter kann einen zwischen seinen Lastanschlüssen (Drain-Anschluss und Source-Anschluss im Falle eines FET, Kollektor-Anschluss und Emitter-Anschluss im Falle eines IGBT) fließenden Überstrom, der beispielsweise durch einen Kurzschluss oder einen Erdschluss verursacht wird, nur eine begrenzte Zeitdauer überstehen, da der Leistungshalbleiterschalter durch Überhitzung beschädigt oder zerstört wird, wenn er dem Überstrom zu lange ausgesetzt ist. Um die Beschädigung des Leistungshalbleiterschalters zu verhindern, muss der Überstrom daher rechtzeitig erkannt und abgeschaltet werden. Mit anderen Worten muss die zur Erkennung und Abschaltung eines Überstroms benötigte Zeitspanne kleiner als die Zeitdauer sein, die der Leistungshalbleiterschalter den Überstrom überstehen kann. Gerade Leistungshalbleiterschalter neueren Typs können hohe Überströme jedoch häufig nur eine Zeitdauer überstehen, die zur Erkennung und Behebung eines Überstroms nicht ausreicht. Derartige Leistungshalbleiterschalter sind beispielsweise so genannte SiC-MOSFET, das heißt Metall-Oxid-Halbleiter-Feldeffekttransistoren (MOSFET = Metal-Oxide-Semiconductor Field-Effect Transistor) auf der Basis von Siliziumcarbid (SiC), und so genannte Si-IGBT, das heißt IGBT auf der Basis von Silizium (Si). Diese neuartigen Leistungshalbleiterschalter sind deutlich kleiner als FET und IGBT älteren Typs und überhitzen daher schneller als FET und IGBT älteren Typs bei gleicher Leistungsaufnahme.

Der Erfindung liegt die Aufgabe zugrunde, den elektrischen Strom in einem als ein FET oder IGBT ausgebildeten Leistungshalbleiterschalter, insbesondere in Wechselrichteranwendungen, zu begrenzen, um die Zeitdauer zu erhöhen, die der Leistungshalbleiterschalter einen Überstrom überstehen kann.

Die Aufgabe wird erfindungsgemäß durch eine Schaltungsanordnung mit den Merkmalen des Anspruchs 1 und einen Wechselrichter mit den Merkmalen des Anspuchs 6 gelöst.

Vorteilhafte Ausgestaltungen der Erfindung sind Gegenstand der Unteransprüche.

Eine erfindungsgemäße Schaltungsanordnung dient dem Begrenzen eines elektrischen Stroms in einem Leistungshalbleiterschalter, der einen ersten Lastanschluss, einen zweiten Lastanschluss und einen Steueranschluss zum Steuern des Stroms zwischen den Lastanschlüssen aufweist. Der Leistungshalbleiterschalter ist entweder ein Feldeffekttransistor (FET), dessen erster Lastanschluss ein Drain-Anschluss ist und dessen zweiter Lastanschluss ein Source-Anschluss ist, oder ein Bipolartransistor mit isoliertem Gate (IGBT), dessen erster Lastanschluss ein Kollektor-Anschluss ist und dessen zweiter Lastanschluss ein Emitter-Anschluss ist. Die Schaltungsanordnung umfasst einen Shuntwiderstand mit einem ersten Shuntpol, der mit dem zweiten Lastanschluss des Leistungshalbleiterschalters elektrisch verbunden ist, und einen Bipolartransistor, dessen Kollektor mit dem Steueranschluss des Leistungshalbleiterschalters elektrisch verbunden ist und dessen Basis-Emitter-Strecke elektrisch parallel zu dem Shuntwiderstand geschaltet ist.

Erfindungsgemäß wird einem als FET oder IGBT ausgebildeten Leistungshalbleiterschalter also ein Shuntwiderstand nachgeschaltet. Zu dem Shuntwiderstand wird die Basis-Emitter-Strecke eines Bipolartransistors parallel geschaltet, dessen Kollektor mit dem Steueranschluss des Leistungshalbleiterschalters verbunden ist. Dadurch wird die an dem Shuntwiderstand abfallende Spannung zwischen die Basis und den Emitter des Bipolartransistors gelegt. Somit wird der Bipolartransistor leitend, wenn die an dem Shuntwiderstand abfallende Spannung groß genug wird (im Falle eines Si-Bipolartransistors beispielsweise größer als etwa 0,6 V), und die Leitfähigkeit des Bipolartransistors wächst mit weiter steigender Spannung, die an dem Shuntwiderstand abfällt. Der zwischen dem Emitter und dem Kollektor durch den Bipolartransistor fließende Strom begrenzt die Steuerspannung des Leistungshalbleiterschalters und dadurch auch den Strom in dem ersten Leistungshalbleiterschalter, das heißt den Strom zwischen den Lastanschlüssen des Leistungshalbleiterschalters. Gewissermaßen "stiehlt" der Bipolartransistor, sobald er leitend ist, also dem Leistungshalbleiterschalter einen Teil dessen Steuerspannung (Gatespannung) und begrenzt dadurch den Strom in dem Leistungshalbleiterschalter.

Durch die Auslegung des Shuntwiderstands kann dabei festgelegt werden, bei welcher Stromstärke des Stroms in dem Leistungshalbleiterschalter der Bipolartransistor leitend wird und die den Strom in dem Leistungshalbleiterschalter begrenzende Wirkung des Bipolartransistors einsetzt, da der in dem Leistungshalbleiterschalter fließende Strom auch durch den Shuntwiderstand fließt und daher den Spannungsabfall an dem Shuntwiderstand bewirkt. Insbesondere kann der Shuntwiderstand derart ausgelegt werden, dass der Bipolartransistor leitend wird, wenn in dem Leistungshalbleiterschalter ein Überstrom fließt, der den Nennstrom des Leistungshalbleiterschalters übersteigt. Dann setzt die den Strom in dem Leistungshalbleiterschalter begrenzende Wirkung des Bipolartransistors ein, wenn in dem Leistungshalbleiterschalter ein Überstrom fließt. Dadurch begrenzt die Schaltungsanordnung Überströme in dem Leistungshalbleiterschalter und erhöht die Zeitdauer, die der Leistungshalbleiterschalter Überströme überstehen kann. Dies wiederum ermöglicht, einen Überstrom über den Shuntwiderstand rechtzeitig zu erkennen und abzuschalten, bevor der Leistungshalbleiterschalter durch einen Überstrom beschädigt wird. Beispielsweise kann der Überstrom in dem Leistungshalbleiterschalter auf etwa dessen dreifachen Nennstrom begrenzt werden.

Eine Ausgestaltung der Erfindung sieht vor, dass der Kollektor des Bipolartransistors mit dem Steueranschluss des Leistungshalbleiterschalters über eine Diode elektrisch verbunden ist, deren Anode mit dem Steueranschluss des Leistungshalbleiterschalters verbunden ist und deren Kathode mit dem Kollektor des Bipolartransistors verbunden ist. Die Diode wird benötigt, wenn die Steuerspannung des Leistungshalbleiterschalters auch negativ werden kann.

Eine weitere Ausgestaltung der Erfindung sieht eine antiparallel zu dem Bipolartransistor geschaltete Schutzdiode vor, deren Anode mit dem Emitter des Bipolartransistors verbunden ist und deren Kathode mit dem Kollektor des Bipolartransistors verbunden ist. Durch die Schutzdiode kann der Bipolartransistor vor einer zu hohen Spannung zwischen seinem Kollektor und seinem Emitter geschützt werden.

Bei weiteren Ausgestaltungen der Erfindung ist der Leistungshalbleiterschalter ein SiC-MOSFET oder ein Si-IGBT. Wie oben bereits ausgeführt wurde, überhitzen diese Leistungshalbleiterschaltertypen schneller durch Überströme als Leistungshalbleiterschaltertypen älteren Typs. Die Erfindung eignet sich daher insbesondere vorteilhaft zum Begrenzen von Überströmen in einem SiC-MOSFET oder Si-IGBT, um die Zeitdauer zu erhöhen, die ein derartiger Leistungshalbleiterschalter Überströme überstehen kann, und die Überströme dadurch rechtzeitig erkennen und abschalten zu können, bevor der Leistungshalbleiterschalter durch einen Überstrom beschädigt wird.

Ein erfindungsgemäßer Wechselrichter zum Umrichten einer Gleichspannung in eine einphasige oder mehrphasige Wechselspannung umfasst für jede Wechselspannungsphase der Wechselspannung einen ersten Leistungshalbleiterschalter und einen zweiten Leistungshalbleiterschalter, die jeweils einen ersten Lastanschluss, einen zweiten Lastanschluss und einen Steueranschluss zum Steuern des Stroms zwischen den Lastanschlüssen aufweisen. Dabei ist jeder Leistungshalbleiterschalter entweder ein FET, dessen erster Lastanschluss ein Drain-Anschluss ist und dessen zweiter Lastanschluss ein Source-Anschluss ist, oder ein IGBT, dessen erster Lastanschluss ein Kollektor-Anschluss ist und dessen zweiter Lastanschluss ein Emitter-Anschluss ist, und der erste Lastanschluss jedes ersten Leistungshalbleiterschalters liegt auf einem ersten Gleichspannungspotential der Gleichspannung. Der Wechselrichter weist ferner für den ersten Leistungshalbleiterschalter jeder Wechselspannungsphase eine erfindungsgemäße Schaltungsanordnung zum Begrenzen eines elektrischen Stroms in dem ersten Leistungshalbleiterschalter auf, wobei der erste Shuntpol des Shuntwiderstands der Schaltungsanordnung mit dem ersten Lastanschluss des zweiten Leistungshalbleiterschalters der Wechselspannungsphase elektrisch verbunden ist und der zweite Shuntpol des Shuntwiderstands der Schaltungsanordnung mit einem Außenleiter der Wechselspannungsphase verbunden ist.

Ein erfindungsgemäßer Wechselrichter weist also für jede Wechselspannungsphase eine Halbbrücke auf, die aus zwei jeweils als ein FET, insbesondere als ein SiC-MOSFET, oder als ein IGBT, insbesondere als ein Si-IGBT, ausgebildeten Leistungshalbleiterschaltern gebildet wird und in deren Brückenzweig ein Shuntwiderstand angeordnet ist, über den die Halbbrücke mit einem Außenleiter der Wechselspannungsphase verbunden ist. Für den ersten Leistungshalbleiterschalter jeder Halbbrücke, das heißt für denjenigen Leistungshalbleiterschalter, dessen zweiter Lastanschluss (Source-Anschluss im Falle eines FET, Emitter-Anschluss im Falle eines IGBT) mit dem Shuntwiderstand verbunden ist, weist der Wechselrichter eine erfindungsgemäße Schaltungsanordnung zum Begrenzen eines Stroms in dem Leistungshalbleiterschalter auf. Dadurch können durch die oben beschriebene Wirkung der Schaltungsanordnung bei entsprechender Auslegung des Shuntwiderstands insbesondere Überströme, die beispielsweise durch einen Kurzschluss verursacht werden, in den ersten Leistungshalbleiterschaltern begrenzt werden. Die Begrenzung der Überströme erhöht wiederum die Zeitdauern, die die ersten Leistungshalbleiterschalter Überströme überstehen können, so dass die Überströme rechtzeitig erkannt und abgeschaltet werden können, bevor sie die ersten Leistungshalbleiterschalter beschädigen.

Eine Ausgestaltung eines erfindungsgemäßen Wechselrichters sieht auch für die zweiten Leistungshalbleiterschalter eine erfindungsgemäße Schaltungsanordnung vor, die einen weiteren Shuntwiderstand und einen weiteren Bipolartransistor aufweist. Ein erster Shuntpol des weiteren Shuntwiderstands ist mit dem zweiten Lastanschluss jedes zweiten Leistungshalbleiterschalters elektrisch verbunden. Der zweite Shuntpol des weiteren Shuntwiderstands liegt auf dem zweiten Gleichspannungspotential der Gleichspannung. Der Kollektor des weiteren Bipolartransistors ist mit dem Steueranschluss jedes zweiten Leistungshalbleiterschalters elektrisch verbunden. Der Emitter des weiteren Bipolartransistors ist mit dem ersten Shuntpol des weiteren Shuntwiderstands elektrisch verbunden. Die Basis des weiteren Bipolartransistors ist mit dem zweiten Shuntpol des weiteren Shuntwiderstands elektrisch verbunden. Dabei kann der Kollektor des weiteren Bipolartransistors mit den Steueranschlüssen der zweiten Leistungshalbleiterschalter jeweils über eine Diode elektrisch verbunden sein, deren Anode mit dem Steueranschluss des zweiten Leistungshalbleiterschalters verbunden ist und deren Kathode mit dem Kollektor des weiteren Bipolartransistors verbunden ist. Ferner kann eine antiparallel zu dem weiteren Bipolartransistor geschaltete Schutzdiode vorgesehen sein, deren Anode mit dem Emitter des weiteren Bipolartransistors verbunden ist und deren Kathode mit dem Kollektor des weiteren Bipolartransistors verbunden ist.

Die vorgenannte Ausgestaltung eines erfindungsgemäßen Wechselrichters begrenzt die Ströme in den zweiten Leistungshalbleiterschaltern und kann insbesondere zum Begrenzen von Überströmen in den zweiten Leistungshalbleiterschaltern ausgebildet sein. Dies ist beispielsweise vorteilhaft, um durch einen Erdschlussfehler verursachte Überströme in den zweiten Leistungshalbleiterschaltern zu begrenzen, um diese Überströme rechtzeitig erkennen und abschalten zu können, bevor sie die zweiten Leistungshalbleiterschalter beschädigen.

Die vorgenannte Ausgestaltung eines erfindungsgemäßen Wechselrichters sieht eine erfindungsgemäße Schaltungsordnung für alle zweiten Leistungshalbleiterschalter des Wechselrichters vor. Die Verwendung einer erfindungsgemäßen Schaltungsordnung für alle zweiten Leistungshalbleiterschalter ist möglich, da die zweiten Lastanschlüsse der zweiten Leistungshalbleiterschalter auf demselben elektrischen Potential liegen. Eine zu dieser Ausgestaltung alternative Ausgestaltung eines mehrphasigen erfindungsgemäßen Wechselrichters sieht für jeden zweiten Leistungshalbleiterschalter eine erfindungsgemäße Schaltungsordnung mit einem dem zweiten Leistungshalbleiterschalter zugeordneten Shuntwiderstand und einem dem zweiten Leistungshalbleiterschalter zugeordneten Bipolartransistor vor. Ein erster Shuntpol des einem zweiten Leistungshalbleiterschalter zugeordneten Shuntwiderstands ist mit dem zweiten Lastanschluss des zweiten Leistungshalbleiterschalters elektrisch verbunden, der zweite Shuntpol liegt auf dem zweiten Gleichspannungspotential der Gleichspannung. Der Kollektor des dem zweiten Leistungshalbleiterschalter zugeordneten Bipolartransistors ist mit dem Steueranschluss des zweiten Leistungshalbleiterschalters elektrisch verbunden. Der Emitter des dem zweiten Leistungshalbleiterschalter zugeordneten Bipolartransistors ist mit dem ersten Shuntpol des dem zweiten Leistungshalbleiterschalter zugeordneten Shuntwiderstands elektrisch verbunden. Die Basis des dem zweiten Leistungshalbleiterschalter zugeordneten Bipolartransistors ist mit dem zweiten Shuntpol des dem zweiten Leistungshalbleiterschalter zugeordneten Shuntwiderstands elektrisch verbunden. Dabei kann der Kollektor jedes einem zweiten Leistungshalbleiterschalter zugeordneten Bipolartransistors mit dem Steueranschluss des zweiten Leistungshalbleiterschalters über eine Diode elektrisch verbunden sein, deren Anode mit dem Steueranschluss des zweiten Leistungshalbleiterschalters verbunden ist und deren Kathode mit dem Kollektor des dem zweiten Leistungshalbleiterschalter zugeordneten Bipolartransistors verbunden ist. Ferner kann der Wechselrichter für jeden einem zweiten Leistungshalbleiterschalter zugeordneten Bipolartransistor eine antiparallel zu dem Bipolartransistor geschaltete Schutzdiode aufweisen, deren Anode mit dem Emitter des Bipolartransistors verbunden ist und deren Kathode mit dem Kollektor des Bipolartransistors verbunden ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit einer Zeichnung näher erläutert werden.

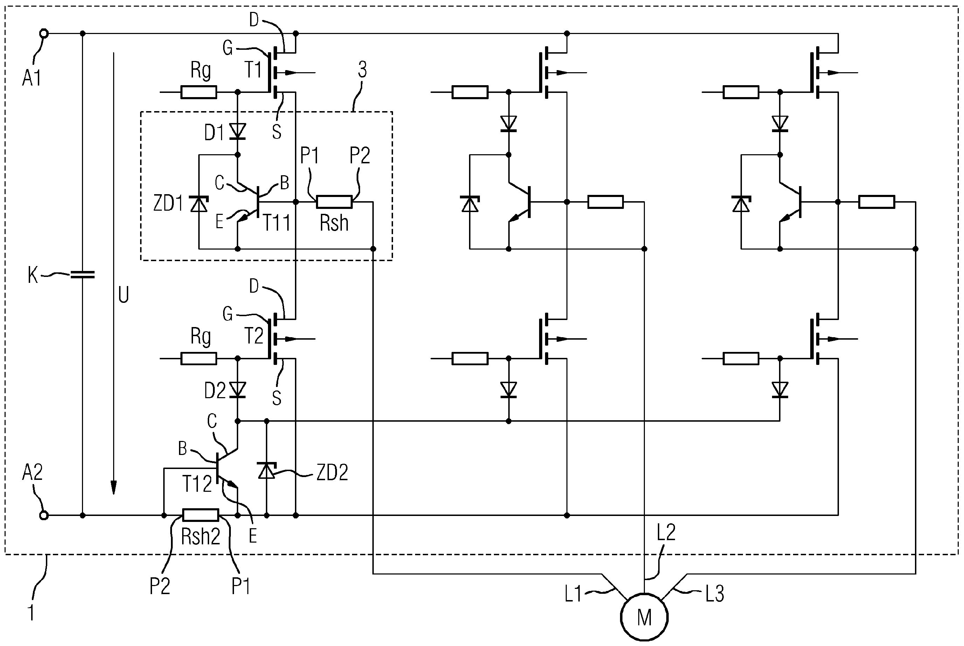

Die einzige Figur zeigt einen Schaltplan eines Ausführungsbeispiels eines Wechselrichters 1 zum Umrichten einer Gleichspannung U in eine dreiphasige Wechselspannung für einen Elektromotor M. Ein erstes Gleichspannungspotential der Gleichspannung U wird an einen ersten Gleichspannungsanschluss A1 des Wechselrichters 1 gelegt. Das zweite Gleichspannungspotential der Gleichspannung U wird an einen zweiten Gleichspannungsanschluss A2 des Wechselrichters 1 gelegt. Zwischen die beiden Gleichspannungsanschlüsse A1, A2 ist ein Kondensator K geschaltet.

Der Wechselrichter 1 weist für jede Wechselspannungsphase der Wechselspannung einen ersten Leistungshalbleiterschalter T1 und einen zweiten Leistungshalbleiterschalter T2 auf. Jeder Leistungshalbleiterschalter T1, T2 weist einen ersten Lastanschluss D, einen zweiten Lastanschluss S und einen Steueranschluss G (Gate-Anschluss) zum Steuern des Stroms zwischen den Lastanschlüssen D, S auf. Der Steueranschluss G ist mit einem Gatewiderstand Rg verbunden. Der erste Lastanschluss D jedes ersten Leistungshalbleiterschalters T1 ist mit dem ersten Gleichspannungsanschluss A1 verbunden und liegt auf dem ersten Gleichspannungspotential der Gleichspannung U. In dem in der Figur dargestellten Ausführungsbeispiel ist jeder Leistungshalbleiterschalter T1, T2 ein MOSFET, beispielsweise ein SiC-MOSFET, dessen erster Lastanschluss D ein Drain-Anschluss ist und dessen zweiter Lastanschluss S ein Source-Anschluss ist.

Ferner weist der Wechselrichter 1 für den ersten Leistungshalbleiterschalter T1 jeder Wechselspannungsphase eine erfindungsgemäße Schaltungsanordnung 3 zum Begrenzen eines elektrischen Stroms in dem ersten Leistungshalbleiterschalter T1 auf. Die Schaltungsanordnung 3 weist einen Shuntwiderstand Rsh, einen Bipolartransistor T11, eine Diode D1 und eine Schutzdiode ZD1 auf. Ein erster Shuntpol P1 des Shuntwiderstands Rsh ist mit dem zweiten Lastanschluss S des Leistungshalbleiterschalters T1 elektrisch verbunden. Der zweite Shuntpol P2 des Shuntwiderstands Rsh ist mit einem Außenleiter L1, L2, L3 der Wechselspannungsphase verbunden. Der Kollektor C des Bipolartransistors T11 ist über die Diode D1 mit dem Steueranschluss G des ersten Leistungshalbleiterschalters T1 elektrisch verbunden, wobei die Anode der Diode D1 mit dem Steueranschluss G des ersten Leistungshalbleiterschalters T1 verbunden ist und die Kathode der Diode D1 mit dem Kollektor C des Bipolartransistors T11 verbunden ist. Der Emitter E des Bipolartransistors T11 ist mit dem zweiten Shuntpol P2 des Shuntwiderstands Rsh elektrisch verbunden. Die Basis B des Bipolartransistors T11 ist mit dem ersten Shuntpol 1 des Shuntwiderstands Rsh elektrisch verbunden. Die Schutzdiode ZD1 ist antiparallel zu dem Bipolartransistor T11 geschaltet, wobei die Anode der Schutzdiode ZD1 mit dem Emitter E des Bipolartransistors T11 verbunden ist und die Kathode der Schutzdiode ZD1 mit dem Kollektor C des Bipolartransistors T11 verbunden ist. Beispielsweise ist die Schutzdiode ZD1 eine Z-Diode.

Die beiden Leistungshalbleiterschalter T1, T2 jeder Wechselspannungsphase bilden also eine Halbbrücke, in deren Brückenzweig der Shuntwiderstand Rsh einer Schaltungsanordnung 3 angeordnet ist. Die an dem Shuntwiderstand Rsh abfallende Spannung wird zwischen die Basis B und den Emitter E des Bipolartransistors T11 der Schaltungsanordnung 3 gelegt. Dadurch wird der Bipolartransistor T11 leitend, wenn die an dem Shuntwiderstand Rsh abfallende Spannung groß genug wird, und die Leitfähigkeit des Bipolartransistors T11 wächst mit weiter steigender Spannung, die an dem Shuntwiderstand Rsh abfällt. Der zwischen dem Emitter E und dem Kollektor C durch den Bipolartransistor T11 fließende Strom begrenzt die Steuerspannung des ersten Leistungshalbleiterschalters T1 und dadurch auch den Strom in dem ersten Leistungshalbleiterschalter T1. Der Shuntwiderstand Rsh wird derart ausgelegt, dass diese den Strom in dem ersten Leistungshalbleiterschalter T1 begrenzende Wirkung des Bipolartransistors T11 einsetzt, wenn in dem ersten Leistungshalbleiterschalter T1 ein Überstrom fließt, der den Nennstrom des ersten Leistungshalbleiterschalters T1 übersteigt. Dadurch begrenzt der Bipolartransistor T11 Überströme in dem ersten Leistungshalbleiterschalter T1 und erhöht die Zeitdauer, die der erste Leistungshalbleiterschalter T1 Überströme überstehen kann. Dies wiederum ermöglicht, diese Überströme über den Shuntwiderstand Rsh rechtzeitig zu erkennen und abzuschalten, bevor der erste Leistungshalbleiterschalter T1 durch die Überströme beschädigt wird.

Um entsprechend Überströme in den zweiten Leistungshalbleiterschaltern T2 zu begrenzen, weist der Wechselrichter 1 ferner einen weiteren Shuntwiderstand Rsh2 und einen weiteren Bipolartransistor T12 auf. Ein erster Shuntpol P1 des weiteren Shuntwiderstands Rsh2 ist mit den zweiten Lastanschlüssen S aller zweiten Leistungshalbleiterschalter T2 elektrisch verbunden. Der zweite Shuntpol P2 des weiteren Shuntwiderstands Rsh2 ist mit dem zweiten Gleichspannungsanschluss A2 des Wechselrichters 1 elektrisch verbunden und liegt auf dem zweiten Gleichspannungspotential der Gleichspannung U. Der Kollektor C des weiteren Bipolartransistors T12 ist über jeweils eine weitere Diode D2 mit den Steueranschlüssen G aller zweiten Leistungshalbleiterschalter T2 elektrisch verbunden, wobei die Anode jeder weiteren Diode D2 mit dem Steueranschluss G eines zweiten Leistungshalbleiterschalters T2 verbunden ist und die Kathode jeder weiteren Diode D2 mit dem Kollektor C des weiteren Bipolartransistors T12 verbunden ist. Der Emitter E des weiteren Bipolartransistors T12 ist mit dem ersten Shuntpol P1 des weiteren Shuntwiderstands Rsh2 elektrisch verbunden. Die Basis B des weiteren Bipolartransistors T12 ist mit dem zweiten Shuntpol P2 des weiteren Shuntwiderstands Rsh2 elektrisch verbunden. Antiparallel zu dem weiteren Bipolartransistor T12 ist eine weitere Schutzdiode ZD2 geschaltet, deren Anode mit dem Emitter E des weiteren Bipolartransistors T12 verbunden ist und deren Kathode mit dem Kollektor C des weiteren Bipolartransistors T12 verbunden ist. Beispielsweise ist die weitere Schutzdiode ZD2 eine Z-Diode.

Das anhand der Figur beschriebene Ausführungsbeispiel eines Wechselrichters 1 kann auf verschiedene Weisen zu weiteren Ausführungsbeispielen abgewandelt werden. Insbesondere können die Leistungshalbleiterschalter T1 jeweils als ein IGBT, insbesondere als ein Si-IGBT, statt als ein MOSFET ausgebildet sein. Ferner kann für jeden zweiten Leistungshalbleiterschalter T2 ein weiterer Shuntwiderstand Rsh2 und ein weiterer Bipolartransistor T12 vorgesehen sein. Des Weiteren kann statt eines Kondensators K eine elektrische Verschaltung mehrerer Kondensatoren K vorgesehen sein. Außerdem können alle diese Ausführungsbeispiele in offensichtlicher Weise auf einen Wechselrichter 1 mit einer von Drei verschiedenen Anzahl von Wechselspannungsphasen geändert werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltungsanordnung (3) zum Begrenzen eines elektrischen Stroms in einem Leistungshalbleiterschalter (T1), der einen ersten Lastanschluss (D), einen zweiten Lastanschluss (S) und einen Steueranschluss (G) zum Steuern des Stroms zwischen den Lastanschlüssen (D, S) aufweist, wobei der Leistungshalbleiterschalter (T1) entweder ein Feldeffekttransistor, dessen erster Lastanschluss (D) ein Drain-Anschluss ist und dessen zweiter Lastanschluss (S) ein Source-Anschluss ist, oder ein Bipolartransistor mit isoliertem Gate, dessen erster Lastanschluss (D) ein Kollektor-Anschluss ist und dessen zweiter Lastanschluss (S) ein Emitter-Anschluss ist, ist, die Schaltungsanordnung (3) umfassend:
- einen Shuntwiderstand (Rsh) mit einem ersten Shuntpol (P1), der mit dem zweiten Lastanschluss (S) des Leistungshalbleiterschalters (T1) elektrisch verbunden ist, und
- einen Bipolartransistor (T11), dessen Kollektor (C) mit dem Steueranschluss (G) des Leistungshalbleiterschalters (T1) elektrisch verbunden ist und dessen Basis-Emitter-Strecke elektrisch parallel zu dem Shuntwiderstand (Rsh) geschaltet ist.

2. Schaltungsanordnung (3) nach Anspruch 1, wobei der Kollektor (C) des Bipolartransistors (T11) mit dem Steueranschluss (G) des Leistungshalbleiterschalters (T1) über eine Diode (D1) elektrisch verbunden ist, deren Anode mit dem Steueranschluss (G) des Leistungshalbleiterschalters (T1) verbunden ist und deren Kathode mit dem Kollektor (C) des Bipolartransistors (T11) verbunden ist.

3. Schaltungsanordnung (3) nach Anspruch 1 oder 2 mit einer antiparallel zu dem Bipolartransistor (T11) geschalteten Schutzdiode (ZD1), deren Anode mit dem Emitter (E) des Bipolartransistors (T11) verbunden ist und deren Kathode mit dem Kollektor (C) des Bipolartransistors (T11) verbunden ist.

4. Schaltungsanordnung (3) nach einem der Ansprüche 1 bis 3, wobei der Leistungshalbleiterschalter (T1) ein Metall-Oxid-Halbleiter-Feldeffekttransistor auf der Basis von Siliziumcarbid ist.

5. Schaltungsanordnung (3) nach einem der Ansprüche 1 bis 3, wobei der Leistungshalbleiterschalter (T1) ein Bipolartransistor mit isoliertem Gate auf der Basis von Silizium ist.

6. Wechselrichter (1) zum Umrichten einer Gleichspannung in eine einphasige oder mehrphasige Wechselspannung, der Wechselrichter (1) umfassend:
- für jede Wechselspannungsphase der Wechselspannung einen ersten Leistungshalbleiterschalter (T1) und einen zweiten Leistungshalbleiterschalter (T2), die jeweils einen ersten Lastanschluss (D), einen zweiten Lastanschluss (S) und einen Steueranschluss (G) zum Steuern des Stroms zwischen den Lastanschlüssen (D, S) aufweisen, wobei jeder Leistungshalbleiterschalter (T1, T2) entweder ein Feldeffekttransistor, dessen erster Lastanschluss (D) ein Drain-Anschluss ist und dessen zweiter Lastanschluss (S) ein Source-Anschluss ist, oder ein Bipolartransistor mit isoliertem Gate, dessen erster Lastanschluss (D) ein Kollektor-Anschluss ist und dessen zweiter Lastanschluss (S) ein Emitter-Anschluss ist, ist und der erste Lastanschluss (D) jedes ersten Leistungshalbleiterschalters (T1) auf einem ersten Gleichspannungspotential der Gleichspannung liegt, und
- für den ersten Leistungshalbleiterschalter (T1) jeder Wechselspannungsphase eine Schaltungsanordnung (3) gemäß einem der vorhergehenden Ansprüche zum Begrenzen eines elektrischen Stroms in dem ersten Leistungshalbleiterschalter (T1), wobei der erste Shuntpol (P1) des Shuntwiderstands (Rsh) der Schaltungsanordnung (3) mit dem ersten Lastanschluss (D) des zweiten Leistungshalbleiterschalters (T2) der Wechselspannungsphase elektrisch verbunden ist und der zweite Shuntpol (P2) des Shuntwiderstands (Rsh) der Schaltungsanordnung (3) mit einem Außenleiter (L1, L2, L3) der Wechselspannungsphase verbunden ist.

7. Wechselrichter (1) nach Anspruch 6, zusätzlich aufweisend:
- einen weiteren Shuntwiderstand (Rsh2) mit einem ersten Shuntpol (P1), der mit dem zweiten Lastanschluss (S) jedes zweiten Leistungshalbleiterschalters (T2) elektrisch verbunden ist, und einem zweiten Shuntpol (P2), der auf dem zweiten Gleichspannungspotential der Gleichspannung liegt, und
- einen weiteren Bipolartransistor (T12) mit einem Kollektor (C), der mit dem Steueranschluss (G) jedes zweiten Leistungshalbleiterschalters (T2) elektrisch verbunden ist, einem Emitter (E), der mit dem ersten Shuntpol (P1) des weiteren Shuntwiderstands (Rsh2) elektrisch verbunden ist, und einer Basis (B), die mit dem zweiten Shuntpol (P2) des weiteren Shuntwiderstands (Rsh2) elektrisch verbunden ist.

8. Wechselrichter (1) nach Anspruch 7, wobei der Kollektor (C) des weiteren Bipolartransistors (T12) mit dem Steueranschluss (G) eines zweiten Leistungshalbleiterschalter (T2) über eine Diode (D2) elektrisch verbunden ist, deren Anode mit dem Steueranschluss (G) des zweiten Leistungshalbleiterschalters (T2) verbunden ist und deren Kathode mit dem Kollektor (C) des weiteren Bipolartransistors (T12) verbunden ist.

9. Wechselrichter (1) nach Anspruch 7 oder 8 mit einer antiparallel zu dem weiteren Bipolartransistor (T12) geschalteten Schutzdiode (ZD2), deren Anode mit dem Emitter (E) des weiteren Bipolartransistors (T12) verbunden ist und deren Kathode mit dem Kollektor (C) des weiteren Bipolartransistors (T12) verbunden ist.

10. Mehrphasiger Wechselrichter (1) nach Anspruch 6, zusätzlich für jeden zweiten Leistungshalbleiterschalter (T2) aufweisend:
- einen dem zweiten Leistungshalbleiterschalter (T2) zugeordneten Shuntwiderstand (Rsh2) mit einem ersten Shuntpol (P1), der mit dem zweiten Lastanschluss (S) des zweiten Leistungshalbleiterschalters (T2) elektrisch verbunden ist, und einem zweiten Shuntpol (P2), der auf dem zweiten Gleichspannungspotential der Gleichspannung liegt, und
- einen dem zweiten Leistungshalbleiterschalter (T2) zugeordneten Bipolartransistor (T12) mit einem Kollektor (C), der mit dem Steueranschluss (G) des zweiten Leistungshalbleiterschalters (T2) elektrisch verbunden ist, einem Emitter (E), der mit dem ersten Shuntpol (P1) des dem zweiten Leistungshalbleiterschalter (T2) zugeordneten Shuntwiderstands (Rsh2) elektrisch verbunden ist, und einer Basis (B), die mit dem zweiten Shuntpol (P2) des dem zweiten Leistungshalbleiterschalter (T2) zugeordneten Shuntwiderstands (Rsh2) elektrisch verbunden ist.

11. Wechselrichter (1) nach Anspruch 10, wobei der Kollektor (C) jedes einem zweiten Leistungshalbleiterschalter (T2) zugeordneten Bipolartransistors (T12) mit dem Steueranschluss (G) des zweiten Leistungshalbleiterschalters (T2) über eine Diode (D2) elektrisch verbunden ist, deren Anode mit dem Steueranschluss (G) des zweiten Leistungshalbleiterschalters (T2) verbunden ist und deren Kathode mit dem Kollektor (C) des dem zweiten Leistungshalbleiterschalter (T2) zugeordneten Bipolartransistors (T12) verbunden ist.

12. Wechselrichter (1) nach Anspruch 10 oder 11, der für jeden einem zweiten Leistungshalbleiterschalter (T2) zugeordneten Bipolartransistor (T12) eine antiparallel zu dem Bipolartransistor (T12) geschaltete Schutzdiode (ZD2) aufweist, deren Anode mit dem Emitter (E) des Bipolartransistors (T12) verbunden ist und deren Kathode mit dem Kollektor (C) des Bipolartransistors (T12) verbunden ist.

13. Wechselrichter (1) nach einem der Ansprüche 6 bis 12, wobei jeder Leistungshalbleiterschalter (T1, T2) ein Metall-Oxid-Halbleiter-Feldeffekttransistor auf der Basis von Siliziumcarbid ist.

14. Wechselrichter (1) nach einem der Ansprüche 6 bis 12, wobei jeder Leistungshalbleiterschalter (T1, T2) ein Bipolartransistor mit isoliertem Gate auf der Basis von Silizium ist.
